Europäisches Patentamt

European Patent Office

Office européen des brevets

(19)

(11) Publication number: **0 062 079**
**B1**

(12) **EUROPEAN PATENT SPECIFICATION**

(45) Date of publication of patent specification: **03.09.86**

(51) Int. Cl.⁴: **H 01 L 21/205, H 01 L 31/04**

(21) Application number: **81902820.0**

(22) Date of filing: **15.10.81**

(86) International application number:
**PCT/JP81/00286**

(87) International publication number:
**WO 82/01441 29.04.82 Gazette 82/11**

(54) **THIN SILICON FILM AND PROCESS FOR PREPARING SAME.**

(30) Priority: **15.10.80 JP 143010/80**

(43) Date of publication of application:
**13.10.82 Bulletin 82/41**

(45) Publication of the grant of the patent:
**03.09.86 Bulletin 86/36**

(84) Designated Contracting States:
**DE FR GB NL**

(56) References cited:
**DE-A-2 508 802**
**US-A-4 226 898**

**Japan. J. Appl. Phys. 19(6), (1980-6), p. L305-L308**

**J. Non-Cryst. Solids. 34, (1979), P. 1-11**
**Appl. Phys. Lett. 37(12), (1980-12), P. 1084-1086**

(73) Proprietor: **THE STATE OF JAPAN, as Represented by the DIRECTOR GENERAL of the AGENCY of INDUSTRIAL SCIENCE and TECHNOLOGY**
**3-1, Kasumigaseki 1-chome Chiyoda-ku Tokyo 100 (JP)**

(73) Proprietor: **TOA NENRYO KOGYO KABUSHIKI KAISHA**
**1-1 Hitotsubashi, 1-Chome Chiyoda-Ku Tokyo 100 (JP)**

(72) Inventor: **IIJIMA, Shigeru Electr Lab, Agen Ind Sci & Techn.**
**1-4, Sakuramura Umezono 1-chome, Niiharigun Ibaraki 305 (JP)**
Inventor: **TANAKA, Kazunobu Electr Lab, Agen Ind Sci & Techn.**
**1-4, Sakuramura Umezono 1-chome, Niiharigun Ibaraki 305 (JP)**
Inventor: **MATSUDA, Akihisa Electr Lab, Agen Ind Sci & Techn.**
**1-4, Sakuramura Umezono 1-chome, Niiharigun Ibaraki 305 (JP)**
Inventor: **MATSUMURA, Mitsuo**
**Toa Nenryo Kogyo K.K. 1-1, Hitotsubashi 1-chome**
**Chiyoda-ku Tokyo 100 (JP)**

Courier Press, Leamington Spa, England.

(72) Inventor: **YAMAMOTO, Hideo**
**Toa Nenryo Kogyo K.K. 1-1, Hitotsubashi 1-**
**chome**
**Chiyoda-ku Tokyo 100 (JP)**


(74) Representative: **Holdcroft, James Gerald, Dr.**
**et al**
**Graham Watt & Co. Riverhead**
**Sevenoaks Kent TN13 2BN (GB)**

## Description

Technical field

This invention relates to a silicon thin film and a method of producing the same, and particularly, to a low resistance silicon thin film which is formed on an appropriate substrate in a plasma atmosphere, and a method of producing the same.

Background art

It is well known to form a silicon thin film on an appropriate substrate in a plasma atmosphere, using as a raw material a mixture of silane $SiH_4$ and a dopant material. The conventional silicon thin film produced by such method is entirely amorphous. The amorphous film produces a halo pattern in the X-ray diffraction, and such amorphous silicon thin film has an electrical conductivity of at most about $10^{-2}\ \Omega^{-1}$ $cm^{-1}$ for the N type and about $10^{-3}\ \Omega^{-1}\ cm^{-1}$ for the P type. The activation energy which is estimated on the basis of the temperature dependence of the electrical conductivity is rather high, that is, about 0.2 eV both for P type and N type films. Thus, it is hard to say that the amorphous thin film is a $P^+$ or $N^+$ type film which has a good ohmic contact to metal and in which the Fermi level is adequately degenerated (for example, see the Philosophical Magazine, 33, p. 935, 1976). Especially, in the P type film, as the electrical conductivity becomes higher, the optical band gap is sharply reduced (see the Physical Review, 19, p. 2041, 1979). As a result, in a P—N junction semiconductor or a P—I—N junction semiconductor for solar cells, due to the reduction of the optical band gap of the P type layer, the light beam which comes through the window or the surface of the P layer is absorbed by the P type layer before it arrives at the active layer of the junction (P and N or P and I interface), a hetero junction is produced at the junction, and the level of the potential barrier becomes lower, so that the open end voltage is lowered. On the other hand, in the N type layer, the fill factor (curve factor of efficiency) is lowered because of the poor ohmic contact to metal and the low series resistance. These facts mean that eventually the efficiency of conversion of the light beam to energy is lowered.

On the other hand, while polycrystalline thin films which are produced of silane $SiH_4$ as by a chemical vapor deposition have higher electrical conductivities, they have optical band gaps as low as 1.2 eV, which is not adequate to the solar spectrum. Further, the grain boundaries between crystals not only act as recombination centers of electron-hole pairs, but also contribute to the leakage of current.

It is an object of the invention to provide a silicon thin film, e.g. on a substrate under a plasma atmosphere, which film has a low electrical resistance and an adequately wide optical band gap with the combined advantages of amorphous silicon thin films and polycrystalline silicon thin films.

Other objects of the invention are to provide a P type silicon thin film having a high electrical conductivity, a wide band gap, and an excellent doping effect, and to provide a N type silicon thin film, having a high electrical conductivity and an excellent doping effect.

According to the present invention, there is provided a silicon thin film composed of primarily silicon atoms, characterised in that said film comprises a dispersion of microcrystalline silicon grains in amorphous silicon, said microcrystalline grains having an average grain diameter in the range of 3 nm to 50 nm and the microcrystalline grains being present in the film in an amount by volume of 20 to 80%.

On X-ray diffraction, amorphous silicon thin films which were prepared under a plasma atmosphere exhibit a halo pattern devoid of any sharp peak, while the polycrystalline silicon thin films which were prepared by chemical vapor deposition, high temperature annealing, etc. exhibit a clear and intensive peak which is derived from the silicon crystal lattice. On the other hand, the silicon thin films according to this invention show a weak peak near Si(111) or Si(220) on the halo pattern, which is presumably derived from the silicon crystal lattice. The average diameter of the microcrystalline grains in the silicon thin film according to this invention can be calculated from the half-value width of the above mentioned peak using the Scherrer equation and, as aforesaid, it ranges from about 3 nm to about 50 nm. The microcrystalline substance in this range of grain diameters does not provide any optical barrier in the range of wave lengths involved in the solar radiation, and can only cause the electrical conductivity to increase. It is deduced that if the microcrystalline substance has an average grain diameter below about 3 nm, it will hardly continue to exist and will tend to lose its crystalline characteristics, thus approaching the amorphous state. If, on the other hand, the microcrystalline substance has an average grain diameter over about 50 nm, it will tend to change into a polycrystalline condition, so that an interference of light at the boundary between the amorphous layer and the crystalline grains will occur. It would then be impossible to lower the electrical resistance without narrowing down the optical band gap. The most desirable range of average grain diameter for the silicon thin film to have a low electrical resistance and a wide optical band gap is about 5 nm to about 20 nm.

Further, the proportion of the microcrystalline substance in the amorphous substance can be estimated from the X-ray diffraction pattern on the basis of the height of peak and the half-value width, and it is about 20 percent by volume to about 80 percent by volume. When the proportion of the microcrystalline substance is below about 20 percent by volume, the electrical characteristic of the silicon thin film becomes similar to that of the amorphous film and the effect due to the dispersion of the crystalline substance does not appear, and consequently, the objects of this invention cannot be accomplished. On the other hand, the existence of the microcrystalline substance over about 80 percent by volume brings forth the disadvantage that the amount of hydrogen in the film is lowered and the optical band gap is narrowed.

It is thought that the existence of the microcrystalline substance in the amorphous layer may closely relate to the fact that the film combines the excellent features (a) of an amorphous silicon thin film, i.e. the adequately wide optical band gap, and (b) of a polycrystalline silicon thin film, i.e. the remarkably high electrical conductivity.

In this invention, various elements can be used as an impurity dopant. Particularly, when elements in the Group V of the Periodic Table, such as phosphorus, arsenic, etc., are used, silicon thin films having a property of N type semiconductor are obtained, while the use of elements in the Group III of the Periodic Table, such as boron, aluminium, etc. will provide a silicon thin film having a property of P type semiconductor. The former films are characterized by the electrical conductivity of about $10^{-1}\Omega^{-1}cm^{-1}$ to about $10^{0}\Omega^{-1}cm^{-1}$, while the latter films are characterized by that of about $10^{-2}\Omega^{-1}cm^{-1}$ to about $10^{-1}\Omega^{-1}cm^{-1}$. By the same doping there can be produced silicon thin films having N type or P type property, which are characterized by the activation energy on the basis of the electrical conductivity below about 0.2 eV, often below about 0.1 eV, a good doping effect, an adequately degenerated Fermi level, and an excellent ohmic contact to metal. Further, the silicon thin films according to this invention, either of a N type or P type, can maintain an adequately wide optical band gap even by added doping, and they have a considerably higher value of about 1.3 eV to about 1.8 eV in comparison with the value of about 1.2 of the polycrystalline films. The P type thin films especially have two excellent characteristics, i.e. high electrical conductivity and wide optical band gap, which could not have been obtained in conventional films. These advantages substantiate the belief that the silicon thin films according to this invention are of a novel crystalline character which is not completely amorphous and not completely polycrystalline.

Next, the method of making the silicon thin film according to this invention will be explained. First, any one of silane $SiH_4$ or halogenated silane $SiH_{0-3}X_{4-1}$ (X represents a halogen element), or a gas mixture including two or more of these gases is diluted with a rare gas such as helium, argon, etc. or a hydrogen gas in a ratio higher than 1:1, and then a dopant gas is added to the diluted gas mixture. The invention is not limited to this particular sequence of mixing and dilution. Electrical energy having a plasma discharge power density higher than about 0.2 W/cm² is applied to the gas mixture to produce a plasma condition, in which a film is formed on a substrate (consisting of glass, plastic, metal, etc.). Then, the impurity atoms as dopant are efficiently incorporated into a silicon network with four coordinations, so that a silicon thin film having a high electrical conductivity can be formed without narrowing down the optical band gap. The purpose for which the silane $SiH_4$ is diluted with hydrogen or rare gas is to control the film forming rate under the applied high electrical energy. Particularly, when a high electrical power is applied in the film forming process, decomposition of silane $SiH_4$ is promoted, so that the film forming rate increases, making it difficult to efficiently incorporate the impurities as dopant into the silicon network with four coordinations. Thus, the silane is diluted with hydrogen or rare gas to suppress the film forming rate in the application of high electric power (preferably, below 0.4 nm/sec).

The X-ray diffraction pattern from the film which has been produced under such condition shows that micro-crystalline grains are interspersed in the amorphous substance, and it is deduced that the existence of such microcrystalline grains remarkably reduces the resistance of the film without detracting from the optical property characteristic of amorphous films.

The invention will now be explained in more detail in the following non-limitative description, taken in conjunction with the accompanying drawings, in which:

Fig. 1 is a schematic view showing an example of an apparatus for carrying out the method of making silicon thin films according to this invention;

Figs. 2 to 5 are graphs showing characteristics of the silicon thin films produced by conventional methods and according to this invention; and

Fig. 6 is a diagram showing the X-ray diffraction pattern of the silicon thin film according to this invention.

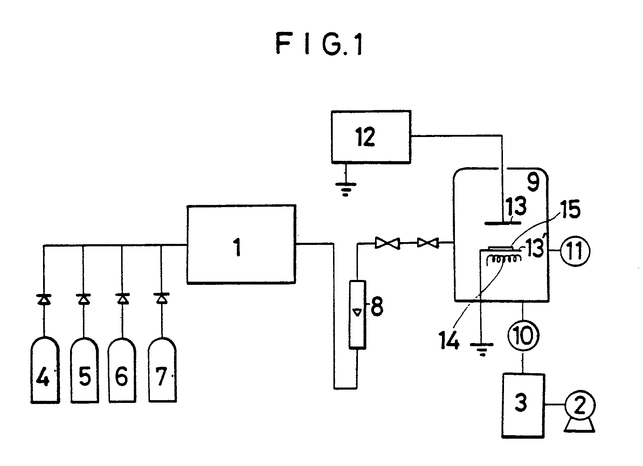

Referring to Fig. 1, the whole system including a mixing chamber 1 is evacuated to a degree of vacuum of about $10^{-6}$ torr (0.133 mPa) using a rotary oil pump 2 and an oil diffusion pump 3, and gases are introduced from a silane source 4, a hydrogen source 5, and from a dopant gas source 6 or 7 as required, to the mixing chamber 1 in a required proportion and are mixed there. The gas mixture is supplied through a flow rate meter 8 to an evacuated chamber 9 at a predetermined flow rate. The pressure or degree of vacuum within the chamber 9 is maintained at a required value by manipulating a main valve 10 while observing a vacuum meter 11. A high frequency voltage is applied across electrodes 13 and 13' to produce a glow discharge. A substrate 15 is placed on a base plate which is heated by a heater 14 to a required temperature. A doped, hydrogenated silicon thin film is produced on the substrate 15.

Table I illustrates examples of the method of producing film according to this invention and the characteristics of the formed films in comparison with the conventional methods and films. In Table I, the samples designated by Nos. 1 to 3 are P type silicon thin films which were prepared by the conventional method, the film forming conditions and film characteristics thereof being given in the Table. The samples designated by Nos. 4 and 5 are P type silicon thin films which were prepared using this invention. In these examples, the silane $SiH_4$ was diluted with hydrogen at a ratio of silane to hydrogen of 1:30 and high electric powers of 0.8W/cm² and 1.6W/cm², respectively were applied. The samples designated by Nos. 6 to 9 and No. 11 are N type silicon thin films which were prepared by the conventional method, while the samples designated by Nos. 10 and 12 are N type silicon thin films which were prepared by this invention. In the Examples Nos. 10 and 12, the silane was diluted with hydrogen at a ratio of silane to hydrogen of 1 to 10 and electrical powers of $0.8 W/cm^2$ and $1.6 W/cm^2$, respectively were applied.

The Table II illustrates other examples of the method of producing silicon thin film according to this invention and the characteristics of the formed films. In Table II, the sample designated by No. 13 is P type silicon thin film which was prepared according to this invention and the film forming conditions and film characteristics thereof are given in the Table. In No. 13, the silane $SiH_4$ was diluted by argon at a ratio of silane to argon of 1:30, high electric power of $1.5 W/cm^2$ was applied, and a mixed gas of $B_2H_6/SiH_4$ of 20,000 ppm by vol. was used as a dopant. The sample designated by No. 14 is N type silicon thin film which was also prepared according to this invention and there are described firm forming conditions and film characteristics thereof. Further, the samples designated by No. 15 and 16 are I layers which were prepared according to this invention. They were formed by diluting the silane $SiH_4$ with argon at a high proportion and applying high electric power.

TABLE (I)

| No. of samples | 1 | 2 | 3 | 4 | 5 | 6 |
|---|---|---|---|---|---|---|
| Composition of gas (volume ratio) | $SiH_4/H_2$=1/1 | 1/1 | 1/1 | 1/30 | 1/30 | $SiH_4/H_2$=9/1 |
| Proportion of doping gas (ppm by vol.) | $\dfrac{B_2H_6}{SiH_4}$=800 | 4,000 | 20,000 | 20,000 | 20,000 | $\dfrac{PF_5}{SiH_4}$=200 |
| Gas flow rate (SCCM) | 15 | 15 | 15 | 19 | 19 | 4 |
| Cathode electric power density $(W/cm^2)$ | 0.1 | 0.1 | 0.1 | 0.8 | 1.6 | 0.14 |
| Temperature of substrate (°C) | 300 | 300 | 300 | 300 | 300 | 320 |
| Film forming pressure (torr) | $5\times10^{-2}$ (6.66 Pa) | $5\times10^{-2}$ (6.66 Pa) | $5\times10^{-2}$ (6.66 Pa) | >1.0 (>133 Pa) | >1.0 (>133 Pa) | $5\times10^{-2}$ (6.66 Pa) |
| Film thickness (µm) | 1.0 | 1.1 | 1.0 | 1.4 | 1.7 | 1.2 |
| Film forming rate (nm/sec.) | 0.093 | 0.11 | 0.093 | 0.13 | 0.16 | 0.092 |
| Electrical conductivity $(\Omega^{-1}cm^{-1})$ | $2.13\times10^{-10}$ | $6.0\times10^{-7}$ | $1.39\times10^{-4}$ | $1.56\times10^{-2}$ | $1.55\times10^{-1}$ | $1.38\times10^{-6}$ |
| Activation energy (eV) | 0.59 | 0.48 | 0.29 | 0.060 | 0.056 | 0.49 |
| Band gap (eV) | 1.75 | 1.66 | 1.50 | 1.76 | 1.80 | 1.74 |
| Crystal grain diameter (nm) | — | — | — | 6 | 5 | — |
| Type of conductivity by measuring electromotive force | ← P type → | | | | | N type |

TABLE I (contd.)

| No. of samples | 7 | 8 | 9 | 10 | 11 | 12 |
|---|---|---|---|---|---|---|
| Composition of gas (volume ratio) | 9/1 | 9/1 | 9/1 | 1/10 | 9/1 | 1/10 |
| Proportion of doping gas (ppm by vol.) | 1,000 | 2,000 | 4,000 | 10,000 | $\dfrac{PH_3}{SiH_4}$=4,000 | 4,500 |
| Gas flow rate (SCCM) | 4 | 4 | 8 | 12 | 8 | 10 |
| Cathode electric power density (W/cm$^2$) | 0.14 | 0.14 | 0.06 | 0.8 | 0.06 | 16 |
| Temperature of substrate (°C) | 320 | 320 | 320 | 280 | 320 | 280 |
| Film forming pressure (torr) | $5\times10^{-2}$ (6.66 Pa) | $5\times10^{-2}$ (6.66 Pa) | $1\times10^{-1}$ (13.3 Pa) | >1.0 (>133 Pa) | $1\times10^{-1}$ (13.3 Pa) | >1.0 (>133 Pa) |
| Film thickness (µm) | 0.83 | 0.84 | 0.80 | 1.1 | 0.76 | 0.70 |
| Film forming rate (Å/sec.) | 0.77 | 0.78 | 0.56 | 1.9 | 0.53 | 3.9 |
| Electrical conductivity (Ω$^{-1}$cm$^{-1}$) | $1.43\times10^{-5}$ | $1.03\times10^{-4}$ | $94\times10^{-4}$ | $5.04\times10^{-1}$ | $3.00\times10^{-4}$ | $2.77\times10^{0}$ |
| Activation energy (eV) | 0.39 | 0.28 | 0.24 | 0.031 | 0.26 | 0.022 |
| Band gap (eV) | 1.74 | 1.73 | 1.75 | 1.78 | 1.72 | 1.73 |
| Crystal grain diameter (nm) | — | — | — | 12 | — | 12 |
| Type of conductivity by measuring electromotive force | ←———————————————— N type ————————————————→ | | | | | |

**0 062 079**

TABLE II

| No. of samples | 13 | 14 | 15 | 16 |
|---|---|---|---|---|
| Composition of gas (volume ratio) | $SiH_4/Ar=1/30$ | $SiH_4/Ar=1/10$ | $SiH_4/H_2=1/30$ | $SiH_4/Ar=1/30$ |
| Proportion of doping gas (ppm by vol.) | $B_2H_6/SiH_4=20,000$ | $PH_3/SiH_4=20,000$ | — | — |
| Gas flow rate (SCCM) | 15 | 10 | 10 | 16 |
| Cathode electric power density $(W/cm^2)$ | 1.6 | 0.8 | 0.8 | 0.8 |
| Temperature of substrate (°C) | 300 | 300 | 300 | 300 |
| Film forming pressure (torr) | 2.0 (266 Pa) | 1.0 (133 Pa) | 1.0 (133 Pa) | $1\times10^{-1}$ (13.3 Pa) |
| Film thickness (μm) | 0.7 | 0.8 | 0.99 | 0.99 |
| Film forming rate (nm/sec.) | 0.070 | 0.080 | 0.10 | 0.10 |
| Electrical conductivity $(\Omega^{-1}cm^{-1})$ | $5\times10^{-2}$ | $1.5\times10^{0}$ | $5\times10^{-4}$ | $5\times10^{-4}$ |
| Activation energy (eV) | 0.059 | 0.025 | 0.3 | 0.29 |
| Band gap (eV) | 1.75 | 1.75 | 1.63 | 1.72 |
| Crystal grain diameter (nm) | 6 | 12 | 12 | 12 |
| Type of conductivity by measuring electromotive force | P type | N type | I layer | I layer |

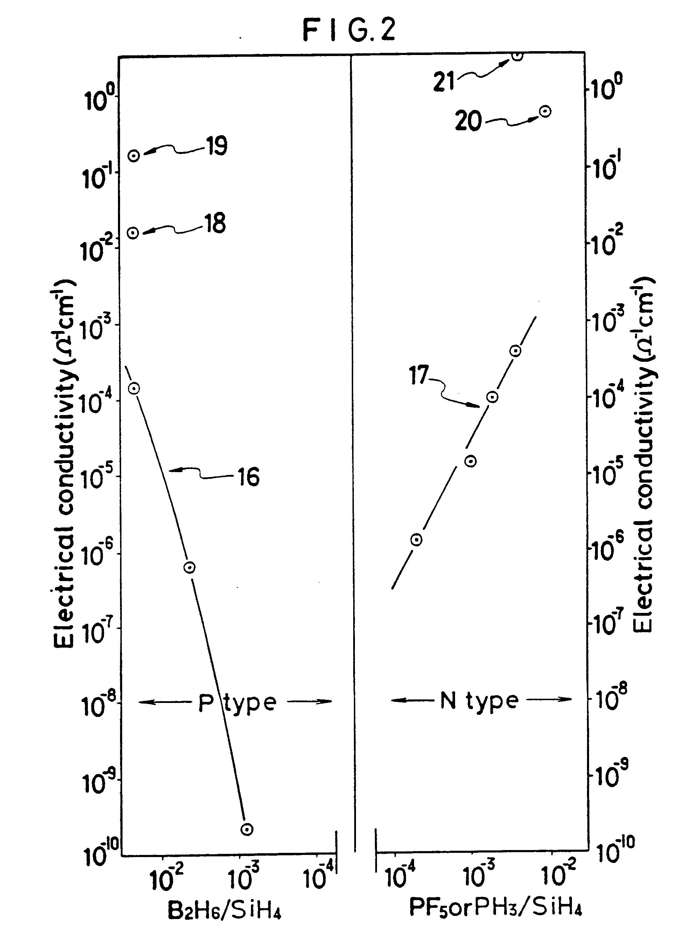

Fig. 2 is a graph showing the electrical conductivity of the silicon thin films as a function of the concentration of dopant gas. In Fig. 2, the curves 16 and 17 show the electrical conductivity of the P type and N type silicon thin films, respectively, produced by the conventional method, in which the films were formed at a cathode plasma discharge power density (fed plasma discharge power/area of cathode electrode) of about $0.1W/cm^2$. The points 18 and 19 shows the electrical conductivity of the P type silicon thin films produced by the method of this invention, in which the silane $SiH_4$ was diluted with hydrogen at ratio of silane to hydrogen of 1:30, and 2% by volume of diborane $B_2H_6$ to silane was added to the gas mixture while plasma discharge power densities of $0.8W/cm^2$ and $1.6W/cm^2$, respectively were employed. The points 20 and 21 in Fig. 2 shows the conductivity of the N type silicon thin films produced by the method of this invention, in which silane was diluted with hydrogen at a ratio of silane to hydrogen of 1:10, and for the point 20, 1% by volume of phosphorus pentafluoride $PF_5$, and for the point 21, 4500 ppm by volume of phosphine $PH_3$ were added while power densities of $0.8W/cm^2$ and $1.6W/cm^2$, respectively were used. Fig. 2 shows that the conductivity of silicon thin films made according to this invention is increased at least by two orders of magnitude in comparison with films produced by the conventional method.

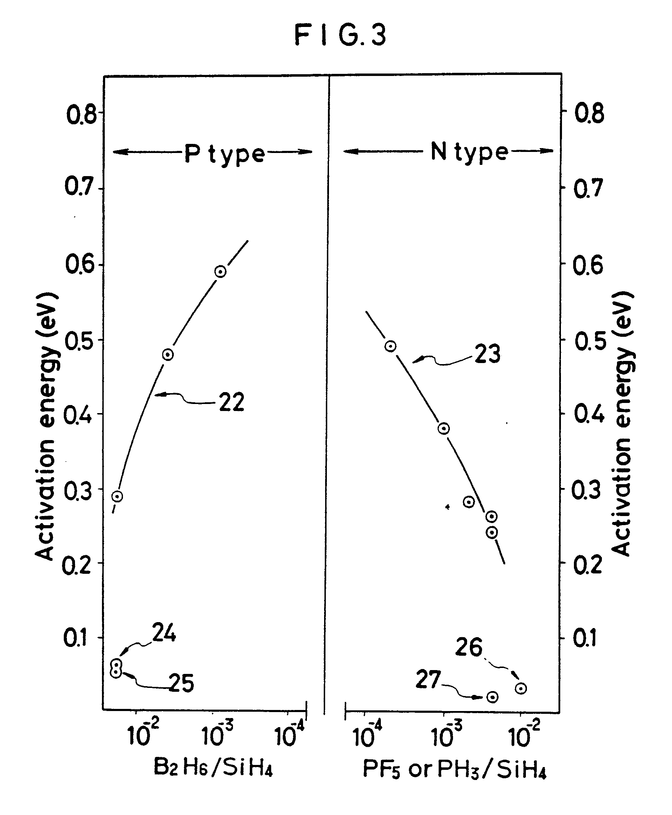

Fig. 3 shows the activation energy on the basis of the electrical conductivity of silicon thin films as a function of the concentration of dopant gas. The curves 22 and 23 in Fig. 3 represent the activation energy of the films produced by the conventional method, for which the film forming conditions corresponding to the curves 16 and 17 in Fig. 2 were used, respectively. The points 24, 25, 26 and 27 represent the activation energy of the films produced by this invention, in which the film forming conditions described in relation to points 18, 19, 20 and 21 of Fig. 2 were used, respectively. Fig. 3 substantiates that this invention provides a

**0 062 079**

p$^+$ type or N$^+$ type film having a low activation energy on the basis of electrical conductivity, a good ohmic contact to metal, and an adequately degenerated Fermi level.

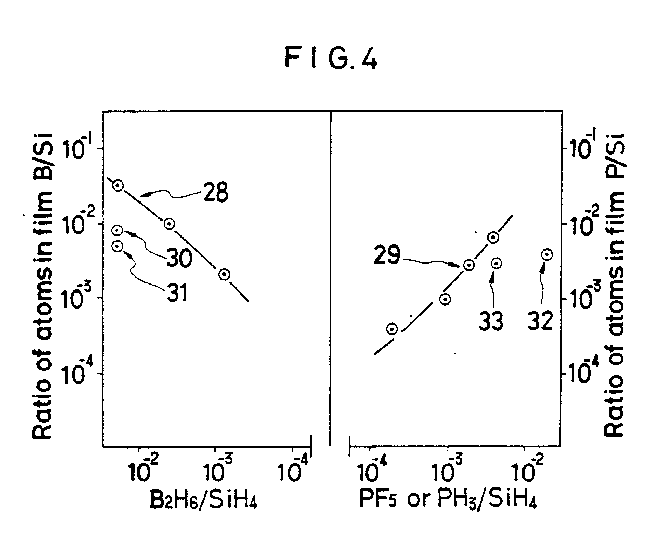

Fig. 4 is a graph showing the concentrations of boron and phosphorus in silicon thin films as a function of the concentration of dopant gas, as measured by the SIMS and EDMA methods. The curves 28 and 29 represent the films produced by the conventional method, in which the film forming conditions corresponding to the curves 16 and 17 in Fig. 2 were used. The points 30, 31, 32 and 33 in Fig. 4 represent the films produced by the method of this invention, in which the film forming conditions described in relation to points 18, 19, 20 and 21 in Fig. 2 were used, respectively. Fig. 4 shows that the concentration of boron and phosphorus in the silicon thin film of this invention is lower than that of the films produced by the conventional method, and substantiates that the film of this invention has an excellent characteristic and the method according to this invention brings about an extremely excellent doping effect.

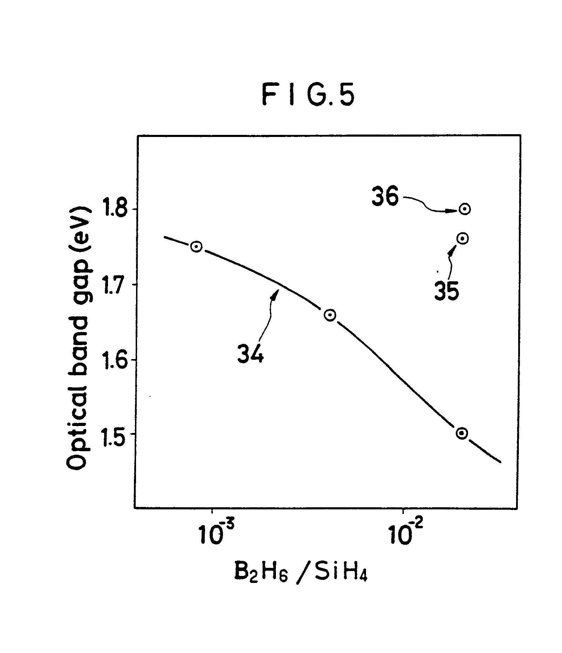

Fig. 5 shows the optical band gap of the P type silicon thin film as a function of the concentration of dopant gas. The optical band gap is calculated on the basis of

$$\sqrt{\alpha h \gamma \alpha} \ (h\gamma - E_o),$$

wherein $\alpha$ represents the absorption coefficient, $h\gamma$ the incident photon energy (eV), and $E_o$, the optical band gap. The curve 34 in Fig. 5 relates to the film produced by the conventional method, in which the film forming conditions were as described for the curve 16 in Fig. 2 were used. It shows that as the concentration of boron increases, the optical band gap decreases. On the other hand, the points 35 and 36 are for the silicon films of this invention, in which the film forming condition as described for the points 18 and 19 in Fig. 2 were employed, respectively. Fig. 5 shows that the P type silicon thin film of this invention has a high electrical conductivity without the optical band gap being narrowed.

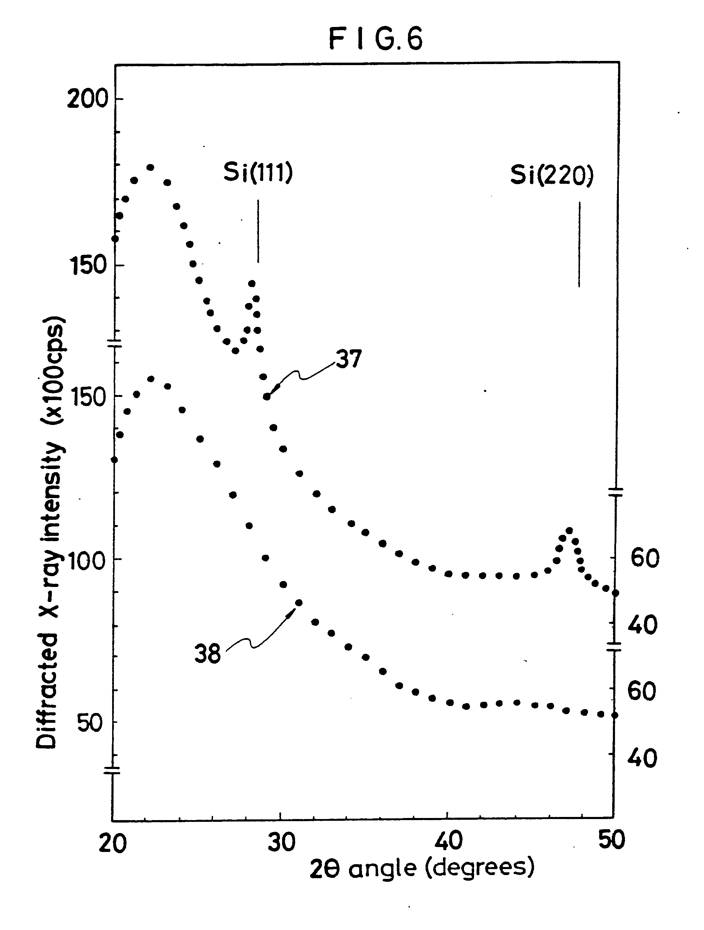

Fig. 6 shows an example of X-ray (CuK$\alpha$) diffraction pattern of silicon thin films (having a film thickness of 1 μm). The curve 37 in Fig. 6 is a representative example of the sample of the invention, in which peaks are observed near Si (111) and Si (220). The grain diameter is calculated from the half-value width of peak to be about 10 nm. The curve 38 in Fig. 6 represents the silicon thin film produced by the conventional method, in which no peak is observed unlike the curve 37. Further, the halo pattern appearing in this Figure is due to the glass material as a substrate, and halo pattern from the amorphous silicon film is not clearly observed, since the film is thin.

Industrial applicability

According to this invention, there can be provided a P type and N type silicon thin film having a high doping effect and a high electrical conductivity, which have a wide application. Especially, P type silicon thin film is useful for solar cells and the like, since it can provide a high electrical conductivity without the optical band gap being narrowed. Thus, this invention has great advantages when used in the electric industries.

**Claims**

1. A silicon thin film composed of primarily silicon atoms, characterised in that said film comprises a dispersion of microcrystalline silicon grains in amorphous silicon, said microcrystalline grains having an average grain diameter in the range of 3 nm to 50 nm and the microcrystalline grains being present in the film in an amount by volume of 20 to 80%.

2. The film according to claim 1, characterised in that the optical band gap of said film is higher than 1.3 eV.

3. The film according to claim 1 or claim 2, characterised by the presence of an impurity element selected from the elements of Group V of the Periodic Table, such as phosphorus, arsenic, etc.

4. The film according to claim 1 or claim 2, characterised by the presence of an impurity element selected from the elements of Group III of the Periodic Table, such as boron, aluminium, etc.

5. The film according to claim 3 or claim 4, characterised in that the electrical conductivity of said film is higher than about $10^{-3}\Omega^{-1}cm^{-1}$.

6. The film according to any of claims 1 to 5, characterised by the activation energy on the basis of the electrical conductivity of said film being below about 0.2 eV.

7. A method of preparing a silicon thin film on a substrate under a plasma atmosphere wherein anyone of silane SiH$_4$ or halogenated silane SiH$_{0-3}$X$_{4-1}$ wherein X represents halogen element, or a combination or two or more thereof is used as a raw material gas, the said gas is diluted with rare gas such as helium, neon, argon, etc. or hydrogen in a ratio of the diluting gas to the said raw material gas higher than 1:1, in order to control the film forming rate adequately enough to produce a film comprising a dispersion of crystalline in amorphous silicon, and an electric power of a plasma discharge power density higher than about 0.2 W/cm$^2$ is applied to cause deposition of said film on the substrate, whereby the crystalline silicon in the deposited film has an average grain diameter in the range of 3 nm to 50 nm and is present in the film in an amount by volume of 20 to 80%.

8. A method according to claim 7, wherein a dopant gas is mixed with the raw material gas for introducing a dopant element into the film.

9

**0 062 079**

9. A method according to claim 8, wherein the dopant gas includes an element selected from the Group III elements of the Periodic Table, such as boron, aluminium, etc. or compounds thereof, and the resulting silicon thin film is of P type.

10. A method according to claim 8, wherein the dopant gas includes an element selected from the Group V elements of the Periodic Table, such as phosphorus, arsenic etc. or compounds thereof, and the resulting silicon thin film is of N type.

## Patentansprüche

1. Dünner Siliciumfilm vorwiegend bestehend aus Siliciumatomen, dadurch gekennzeichnet, daß der Film aus einer Dispersion von mikrokristallinen Siliciumkörnern in amorphem Silicium besteht, wobei die Siliciumkörner einen Durchmesser im Bereich von ca. 3 nm, bis 50 nm aufweisen und mit einem Volumenanteil von 20 bis 80% im Film vorhanden sind.

2. Film nach Anspruch 1, dadurch gekennzeichnet, daß die optische Bandlücke des Films größer ist als 1,3 eV.

3. Film nach Anspruch 1 oder 2, dadurch gekennzeichnet, daß ein aus den Elementen der Gruppe V des Periodensystems ausgewähltes Fremdelement wie z.B. Phosphor, Arsen usw. vorhanden ist.

4. Film nach Anspruch 1 oder 2, dadurch gekennzeichnet, daß ein aus den Elementen der Gruppe III des Periodensystems ausgewähltes Fremdelement wie z.B. Bor (Borium), Aluminium usw. vorhanden ist.

5. Film nach Anspruch 3 oder 4, dadurch gekennzeichnet, daß die elektrische Leitfähigkeit des Filmes größer ist als ca. $10^{-3}\Omega^{-1}cm^{-1}$.

6. Film nach Anspruch 1 bis 5, dadurch gekennzeichnet, daß die Aktivierungsenergie auf der Grundlage der elektrischen Leitfähigkeit geringer ist als etwa 0,2 eV.

7. Verfahren zur Herstellung eines dünnen Siliciumfilmes auf einem Substrat unter einer Plasmaatmosphäre, bei dem irgendein Silan $SiH_4$ oder halogenisiertes Silan $SiH_{0-3}X_{4-1}$, worin X das halogene Element darstellt, oder eine Kombination aus zwei oder mehr davon als Rohstoffgas verwendet wird, das mit Edelgas wie z.B. Helium, Neon, Argon oder Hydrogen usw. verdünnt ist in einem Verhältnis von Verdünnungsgas zu Rohstoffgas größer 1:1, um die Filmbindlungsgeschwindigkeit für die Herstellung eines Filmes aus einer Dispersion von Kristallen in amorphem Silicium genügend kontrollieren zu können, und bei dem elektrische Energie mit einer Plasmaentladungsleistungsdichte größer als ca. 0,2 W/cm² zugeführt wird, um das Abscheiden des Filmes auf dem Substrat zu bewirken, wobei das kristalline Silicium in dem Film einen Korndurchmesser von 3 nm bis 50 nm aufweist und mit einem Volumenanteil von 20 bis 80% im Film vorliegt.

8. Verfahren nach Anspruch 7, bei dem ein Dotierungsstoffgas mit dem Rohstoffgas vermischt wird, um in den Film ein dotierendes Element einzufügen.

9. Verfahren nach Anspruch 8, bei dem das Dotierungsstoffgas ein aus der Gruppe III des Periodensystems ausgewähltes Element wie z.B. Bor, Aluminium usw. oder Verbindungen daraus enthält, und der entstandene dünne Siliciumfilm vom P-Typ ist.

10. Verfahren nach Anspruch 8, bei dem das Dotierungsstoffgas ein aus der Gruppe V des Periodensystems ausgewähltes Element wie z.B. Phosphor, Arsen oder Verbindungen daraus enthält, und der entstandene dünne Siliciumfilm vom N-Typ ist.

## Revendications

1. Revêtement mince de silicium composé primairement d'atomes de silicium, caractérisé en ce que ledit film est composé d'une dispersion de grains de silicium microcristallin dans du silicium amorphe, les grains microcristallins ayant un diamètre moyen dans la bande de 3 nm à 50 nm et les grains microcristallins étant présents dans le film en une quantité de 20 à 80% en volume.

2. Revêtement selon la revendication 1, caractérisé en ce que la largeur de bande optique du revêtement est supérieure à 1,3 eV.

3. Revêtement selon la revendication 1 ou 2, caractérisé par la présence d'un élément d'impureté choisi des éléments du groupe V du tableau périodique, tel que le phosphore, l'arsenic, etc.

4. Revêtement selon la revendication 1 ou 2, caractérisé par la présence d'un élément d'impureté choisi des éléments du groupe III du tableau périodique, tel que le bore, l'aluminium, etc.

5. Revêtement selon la revendications 3 ou 4, caractérisé en ce que la conductivité électrique du revêtement est supérieure à environ $10^{-3}\Omega^{-1}cm^{-1}$.

6. Revêtement selon l'une quelconque des revendications 1 à 5, caractérisé en ce que l'énergie d'activation sur la base de la conductivité électrique du revêtement est inférieure à environ 0,2 eV.

7. Procédé de préparation d'un revêtement mince de silicium sur un substrat sous une atmosphère plasmatique dans laquelle un quelconque de silane $SiH_4$ ou de silane halogéné $SiH_{0-3}X_{4-1}$ dans lequel X représente l'élément halogène, ou une combination de deux ou plusieurs de ceux-ci est utilisée comme matière gazeuse brute, ledit gaz est dilué avec un gaz rare, tel que l'helium, le néon, l'argon, etc., ou l'hydrogène dans un rapport de gaz diluant à ladite matière gazeuse brute supérieur à 1:1, afin de contrôler la vitesse de formation du revêtement d'une manière suffisamment adéquate pour produire un revêtement comprenant une dispersion cristalline dans du silicium amorphe, et une puissance électrique de la puisance volumique des charges plasmatiques supérieure à environ 0,2 W/cm$^2$ est appliquée pour causer le dépôt du revêtement sur le substrat, de sorte que le silicium cristallin dans le revêtement déposé a un diamètre de grains moyen dans la bande de 3 nm à 50 nm et est présent dans le revêtement en une quantité de 20 à 80% par volume.

8. Procédé selon la revendication 7, dans lequel un gaz dopant est mélangé avec la matière gazeuse brute pour introduire un élément dopant dans le revêtement.

9. Procédé selon la revendication 8, dans lequel le gaz dopant est un élément choisi des éléments du groupe III du tableau périodique, tel que le bore, l'aluminium, etc., ou des composés de ceux-ci, et que le revêtement mince de silicium résultant est du type P.

10. Procédé selon la revendication 8, dans lequel le gaz dopant contient un élément choisi des éléments du groupe V du tableau périodique, tel que le phosphore, l'arsenic, etc., ou des composés de ceux-ci, et que le revêtement mince de silicium résultant est du type N.

# F I G.1

# F I G. 2

FIG.3

FIG.4

# F I G.5

# F I G.6